Europäisches Patentamt

European Patent Office

Office européen des brevets

(19)

(11) Veröffentlichungsnummer: **0 490 076 A1**

## (12) EUROPÄISCHE PATENTANMELDUNG

(21) Anmeldenummer: **91118595.7**

(22) Anmeldetag: **31.10.91**

(51) Int. Cl.⁵: **H03G 1/04**, H03G 3/00, G01L 23/22

(30) Priorität: **08.12.90 DE 4039264**

(43) Veröffentlichungstag der Anmeldung:
**17.06.92 Patentblatt 92/25**

(84) Benannte Vertragsstaaten:
**DE ES FR IT SE**

(71) Anmelder: **ROBERT BOSCH GMBH**
**Postfach 30 02 20**
**W-7000 Stuttgart 30(DE)**

(72) Erfinder: **Dreyer, Adolf, Dipl.-Ing.**
**Freiherr-V-Varnbühl Strasse**
**W-7254 Hemmingen(DE)**
Erfinder: **Landsmann, Gerhard, Dipl.-Ing.**
**Hamburger Strasse 34**
**W-6090 Rüsselsheim(DE)**

(74) Vertreter: **Friedmann, Jürgen, Dr.-Ing. et al**
**c/o Robert Bosch GmbH Robert-Bosch-Platz 1**
**W-7016 Gerlingen-Schillerhöhe(DE)**

(54) **Einrichtung zur variablen Signalverstärkung bei einer Klopferkennung.**

(57) Es wird eine Einrichtung zur variablen Signalverstärkung beschrieben, in der die Ausgangssignalspannung eines Sensors (KL), beispielsweise eines Klopfsensors über einen Hochpaß (C1,R11) einer Verstärkeranordnung (OP) zugeführt wird, deren Verstärkungsfaktor variabel eingestellt werden kann. Da sich in feuchter Umgebung parallel zu den eingesetzten Kondensatoren (C1,C2,C4) Ableitwiderstände (R10, R11, R13) bilden können, über die eine Gleichspannung an den Eingang des Verstärkers (OP) gelangen kann, die zum Übersteuern des Verstärkers führt, ist der Verstärker (OP) so beschaltet, daß die Gleichspannung infolge starker Gegenkopplung nur wenig verstärkt wird, während die Wechselspannung einstellbar verstärkt wird.

FIG. 2

## Stand der Technik

Die Erfindung geht aus von einer Einrichtung nach der Gattung des Hauptanspruchs.

Das unter bestimmten Betriebsbedingungen einer Brennkraftmaschine auftretende sogenannte Klopfen kann zur Zerstörung der Brennkraftmaschine führen und muß daher rechtzeitig und mit großer Sicherheit erkannt werden. Dazu wird üblicherweise das von einem Klopfsensor abgegebene Ausgangssignal analysiert und beim Auftreten vorgebbarer Bedingungen wird Klopfen erkannt. Da die Höhe des vom Klopfsensor gelieferten Ausgangssignals sehr stark von der Drehzahl der Brennkraftmaschine abhängig ist, ist es für eine genaue Auswertung nötig, das Signal drehzahlabhängig mehr oder weniger stark zu verstärken. Dazu wird das Signal über eine umschaltbare Verstärkerstufe geleitet, wobei die Einstellung des Verstärkungsfaktors der Verstärkerstufe beispielsweise in Abhängigkeit vom vorhergehenden Meßwert erfolgt.

Aus der DE-OS 33 19 458 ist eine solche Klopferkennung bekannt, bei der das vom Klopfsensor gelieferte Ausgangssignal vor der Weiterverarbeitung in einer einstellbaren Verstärkerstufe in Abhängigkeit vom vorhergehenden Meßwert verstärkt wird. Angesteuert wird die Verstärkerstufe bei dieser bekannten Einrichtung mit Hilfe eines Mikrocomputers.

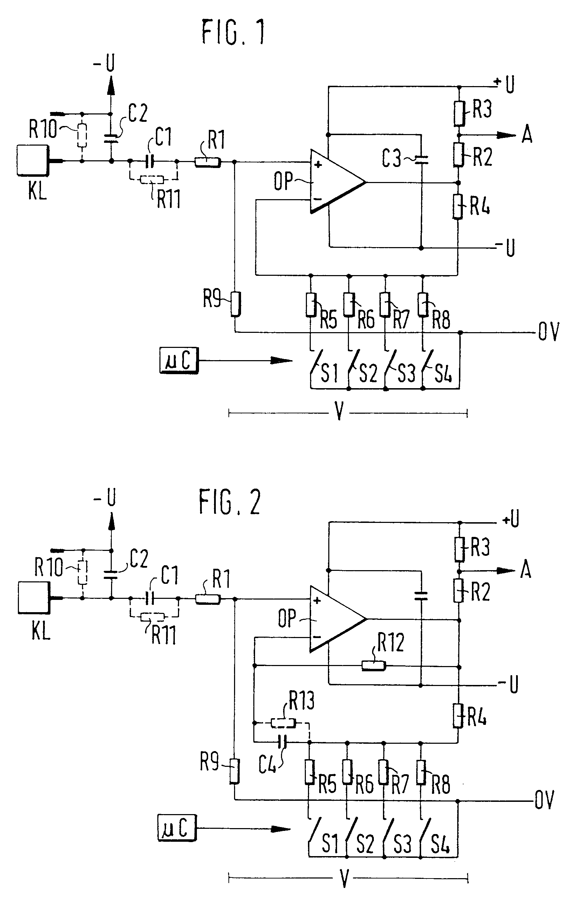

Aufgebaut sind solche bekannte Verstärkerstufen üblicherweise nach einer in Figur 1 abgebildeten Schaltungsanordnung. Dabei werden die Gleichspannungsanteile in einem Hochpaß von den Wechselspannungsanteilen abgetrennt, so daß nur die Wechselspannungsanteile des Signals der variablen Verstärkung zugeführt werden. Nachteilig ist bei der bekannten Schaltungsanordnung, daß bei möglicherweise auftretender Feuchtigkeit parallel zu den Eingangskondensatoren Ableitwiderstände entstehen können, die dazu führen, daß dem Eingang des Verstärkers ein Gleichspannungssignal zugeführt wird, das bei hoch eingestellter Verstärkung den Verstärker bereits so hoch aussteuert, daß das Nutzsignal nicht mehr verzerrungsfrei verstärkt werden kann.

## Vorteile der Erfindung

Die erfindungsgemäße Einrichtung mit den kennzeichnenden Merkmalen des Hauptanspruchs hat demgegenüber den Vorteil, daß die Einstellung der Verstärkung sich nur noch auf das zu verstärkende Wechselspannungs-Nutzsignalauswirkt, da das Gleichspannungssignal durch den zusätzlichen Kondensator ausgefiltert wird. Ein gegebenenfalls am Eingang des Verstärkers entstehendes Gleichspannungssignal wird über eine separate Gegenkopplung des Verstärkers, die zu einem Verstärkungsfaktor von etwa 1 für die Gleichspannung führt, auf geringe Werte beschränkt. Damit können unerwünschte, jedoch infolge von Feuchtigkeit möglicherweise auftretende Ableitwiderstände parallel zu den eingesetzten Kondensatoren kompensiert werden.

## Zeichnung

Die Erfindung ist in der Zeichnung dargestellt und wird in der nachfolgenden Beschreibung näher erläutert. Dabei ist in Figur 1 eine bekannte Schaltungsanordnung mit umschaltbarer Verstärkung dargestellt, bei der auch die möglicherweise auftretenden und unerwünschten Ableitwiderstände eingezeichnet sind. In Figur 2 ist eine erfindungsgemäße Schaltungsanordnung zur variablen Verstärkung dargestellt, bei der die möglicherweise auftretenden Ableitwiderstände keine Übersteuerung des Verstärkres verursachen können.

## Beschreibung des Ausführungsbeispiels

In Figur 1 ist mit K1 ein Klopfsensor bezeichnet, der über einen Kondensator C1 sowie einen Widerstand R1 mit dem nichtinvertierenden Eingang eines Verstärkers, beispielsweise eines Operationsverstärkers OP verbunden ist, wobei der Kondensator C1 und der Widerstand R1 einen Hochpaß darstellen. Über einen weiteren Kondensator C2 ist der Verbindungspunkt zwischen dem Klopfsensor KL und dem Kondensator C1 an die negative Spannung -U angeschlossen.

Der Verstärker OP ist zwischen positive und negative Spannung +U, -U gelegt, ein Kondensator C3 liegt ebenfalls an +U und -U. Der Ausgang des Operationsverstärkers OP ist über eine Reihenschaltung der Widerstände R2 und R3 ebenfalls an die positive Spannung +U gelegt, über einen weiteren Widerstand R4 ist er mit dem invertierenden Eingang verbunden.

Weitere Widerstände R5, R6, R7, R8 sind an den invertierenden Eingang des Verstärkers OP angeschlossen, sie können durch Schaltmittel, beispielsweise durch Schalter S1, S2, S3, S4 und einem Widerstand R9 an den nichtinvertierenden Eingang des Verstärkers OP angeschlossen werden, die Ansteuerung dieser Schalter erfolgt über einen Mikrocomputer $\mu$C. Der vom Operationsverstärker OP abgewandte Anschluß von R9 soll stets auf OV liegen.

Das Ausgangssignal A wird bei der bekannten Schaltungsanordnung am Verbindungspunkt der Widerstände R2 und R3 abgegriffen. Die mit V bezeichnete Anordnung, einschließlich der $\mu$C-Ansteuerung bildet eine variable Verstärkerstufe.

Der Wechselspannungsanteil des vom Klopfsensor KL gelieferten Ausgangssignales kann über den Hochpaß C1, R1 zum Verstärker OP gelangen, während ein eventuell auftretender Gleichspannungsanteil nicht passieren kann. Die am Verstärker OP anliegende Wechselspannung wird je nach Stellung der Schalter S1 bis S4 unterschiedlich stark verstärkt, so daß am Ausgang A ein Signal abgegriffen werden kann, dessen absolute Höhe unabhängig von der Höhe des Ausgangssignals des Klopfsensors KL ist.

Erreicht wird diese unterschiedliche Verstärkung durch Veränderung des zwischen den Ausgang und den nichtinvertierenden Eingang des Operationsverstärkers schaltbaren Gesamtwiderstandes R4 bis R9, wobei im $_/$uC in Abhängigkeit von vorhergehenden Klopfsignalen festgelegt wird, wie hoch dieser Gesamtwiderstand sein soll. Je nach dem werden die Schalter S1 bis S4 durch dem $_/$uC geöffnet oder geschlossen. Die Schaltungsanordnung nach Figur 1 funktioniert jedoch nur dann zuverlässig, wenn sichergestellt ist, daß am Eingang des Verstärkers OP nur Wechselspannungssignale anliegen.

Befindet sich die Schaltung jedoch in feuchter Umgebung, können sich parallel zu den Kondensatoren C1 und C2 Ableitwiderstände R10, R11 bilden, die dazu führen, daß dem Eingang des Verstärkers auch eine Gleichspannung zugeführt wird. Da der Verstärker OP als Gleichspannungsverstärker beschaltet ist, steuert er zu hoch aus, wodurch er nicht mehr in der Lage ist, das auszuwertende Wechselspannungssignal verzerrungsfrei zu verstärken.

In Figur 2 ist ein Ausführungsbeispiel der Erfindung dargestellt, das von einer bekannten Schaltungsanordnung nach Figur 1 ausgeht, jedoch die Nachteile, die Probleme bei auftretender Feuchtigkeit betreffen, nicht mehr aufweist. Die Schaltungsanordnung nach Figur 2 weist weitgehend dieselben Elemente auf wie die Schaltung nach Figur 1, sie weisen die gleichen Bezugszeichen auf und werden nicht mehr getrennt beschrieben.

Im Gegensatz zur Schaltung nach Figur 1 ist jedoch bei der Schaltung nach Figur 2 zwischen den invertierenden Eingang des Verstärkers OP und die Parallelschaltung der Widerstände R5 bis R8 ein Kondensator C4 geschaltet. Weiterhin ist zwischen den Ausgang des Verstärkers OP und seinem invertierenden Eingang ein Widerstand R12 geschaltet.

Die Funktionsweise der Schaltung nach Figur 2 entspricht, was identische Bauteile betrifft, der Funktion der Schaltung nach Figur 1, durch die zusätzlichen Bauelemente werden jedoch folgende Funktionen realisiert:
Der Kondensator C4 im zuschaltbaren Rückkoppelzweig verhindert, daß Gleichspannungen vom Ausgang des Verstärkers OP auf seinen invertierenden Eingang zurückgekoppelt werden, es werden daher ausschließlich Wechselspannungsanteile verstärkt. Auch wenn über die in feuchter Umgebung möglicherweise auftretenden Ableitwiderstände R10 und R11 Gleichspannungen an den Eingang des Verstärkers OP gelangen können, ist damit sichergestellt, daß eine Übersteuerung des Verstärkers OP nicht auftreten kann.

Die Gleichspannungsverstärkung des Operationsverstärkers OP wird über einen weiteren Zweig zwischen dem Ausgang des Verstärkers und dem invertierenden Eingang eingestellt, durch geeignete Dimensionierung des Widerstandes R12 wird sie so eingestellt, daß der Verstärkungsfaktor für die Gleichspannungsverstärkung etwa gleich 1 oder wenigstens kleiner als 1.2 ist. Dies wird erreicht durch eine starke Gegenkopplung der Gleichspannung auf den Eingang. Damit kann auch über diese feste Gleichspannungsverstärkung keine Übersteuerung des Verstärkers als Folge der Ableitwiderstände R10, R11 auftreten.

Eine Übersteuerung ist auch dann nicht möglich, wenn der zusätzliche Kondensator C4 in feuchter Umgebung ebenfalls einen parallel liegenden Ableitwiderstand R13 bekommt, da die starke Gegenkopplung der Gleichspannung dies verhindert.

Die Schaltung nach Figur 2 stellt einen Hochpaß dar, dessen Grenzfrequenz von der Verstärkung abhängt. Bei der Dimensionierung der Schaltung ist daher darauf zu achten, daß die Grenzfrequenz nicht in einem Frequenzbereich liegt, in dem auch die auszuwertenden Signale liegen können.

**Patentansprüche**

1. Einrichtung zur variablen Signalverstärkung, mit einem Sensor, vorzugsweise einem Klopfsensor, dessen Ausgangssignalspannung über einen Hochpaß einem ersten Eingang einer Verstärkeranordnung zugeführt wird, wobei die Verstärkeranordnung Mittel zur Einstellung der Verstärkung aufweist, die zwischen dem zweiten Eingang und dem Ausgang liegen, dadurch gekennzeichnet, daß die Mittel zur Einstellung der Verstärkung nur für anliegende Wechselspannungen wirksam sind und weitere Mittel zur festen Verstärkung für anliegende Gleichspannungen vorgesehen sind.

2. Einrichtung nach Anspruch 1, dadurch gekennzeichnet, daß die Mittel zur Einstellung der Verstärkung Widerstände (R4 bis R9) sind, die zwischen den Ausgang eines Verstärkers (OP) und seinen nicht invertierenden Eingang schaltbar sind, die weiterhin über einen Kondensator (C4) mit dem invertierenden Eingang des Verstärkers (OP) verbunden sind und daß die weiteren Mittel zur festen Verstärkung einen Widerstand (R12) umfassen, der zwischen dem Ausgang des Verstärkers (OP) und seinem invertierenden Eingang liegt.

3. Einrichtung nach Anspruch 1 oder 2, dadurch gekennzeichnet, daß die feste Verstärkung etwa gleich 1 ist.

4. Einrichtung nach Anspruch 2, dadurch gekennzeichnet, daß die feste Verstärkung durch geeignete Dimensionierung des Widerstandes (R12) zu eins gemacht wird.

5. Einrichtung nach einem der vorhergehenden Ansprüche, dadurch gekennzeichnet, daß der Hochpaß aus der Reihenschaltung eines Kondensators (C1) und eines Widerstandes (R1) besteht.

# FIG. 1

# FIG. 2

5

Europäisches
Patentamt

# EUROPÄISCHER RECHERCHENBERICHT

Nummer der Anmeldung

EP 91 11 8595

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EDN ELECTRICAL DESIGN NEWS. Bd. 30, Nr. 12, 30. Mai 1985, NEWTON, MASSACHUSETTS US Seite 281; CH. PAUL: 'High-gain amp yields low dc output offset.' * das ganze Dokument * --- | 1,3 | H03G1/04 H03G3/00 G01L23/22 |
| A | PATENT ABSTRACTS OF JAPAN vol. 13, no. 541 (E-854)5. Dezember 1989 & JP-A-1 223 810 ( TOSHIBA CORP. ) 6. September 1989 * Zusammenfassung * --- | 1 | |
| A | EP-A-0 175 915 (ROBERT BOSCH GMBH) * das ganze Dokument * ----- | 1 | |

| | RECHERCHIERTE SACHGEBIETE (Int. Cl.5) |
|---|---|
| | H03G G01L |

Der vorliegende Recherchenbericht wurde für alle Patentansprüche erstellt

| Recherchenort | Abschlußdatum der Recherche | Prüfer |
|---|---|---|
| DEN HAAG | 16 MAERZ 1992 | DECONINCK E. |

EPO FORM 1503 01.82 (P0403)

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
...........................................................................
& : Mitglied der gleichen Patentfamilie, übereinstimmendes Dokument